Europäisches Patentamt

European Patent Office

Office européen des brevets

(19)

(11) Veröffentlichungsnummer: **0 130 321**
**A2**

(12) **EUROPÄISCHE PATENTANMELDUNG**

(21) Anmeldenummer: 84105352.3

(22) Anmeldetag: 11.05.84

(51) Int. Cl.⁴: **H 03 J 1/04**

(30) Priorität: 30.06.83 DE 3323524

(43) Veröffentlichungstag der Anmeldung: 09.01.85
Patentblatt 85/2

(84) Benannte Vertragsstaaten: **AT CH DE FR GB IT LI SE**

(71) Anmelder: **Blaupunkt-Werke GmbH,
Robert-Bosch-Strasse 200, D-3200 Hildesheim (DE)**

(72) Erfinder: **Kirstein, Horst, Dipl.-Ing., Blauer Kamp 48,
D-3200 Hildesheim (DE)**
Erfinder: **Suppa, Karl-Heinz, Dipl.-Ing., An den Vier
Linden 21, D-3200 Hildesheim (DE)**
Erfinder: **Wolkewitz, Klaus, Stettiner Strasse 3,
D-3200 Hildesheim (DE)**
Erfinder: **Seitz, Manfred, Dipl.-Kfm., Am Blänkebach 4,
D-3200 Hildesheim (DE)**

(74) Vertreter: **Eilers, Norbert, Dipl.-Phys., Blaupunkt-Werke
GmbH Robert-Bosch-Strasse 200, D-3200 Hildesheim
(DE)**

(54) **Autoempfänger.**

(57) Es wird ein Auto-Empfänger mit einer beleuchteten
Abstimmanzeige und mit einer Erkennungsschaltung für
zusätzlich mit einem Pilotton versehene Sendungen vorgeschlagen, bei welchen die Pilottonerkennungsschaltung
zwei zur Beleuchtung der Abstimmanzeige vorgesehene
Lichtquellen unterschiedlicher Lichtfarbe über einen elektrischen Umschalter derart umschaltet, daß die Lichtfarbe
der Abstimmanzeige beim Empfang eines Senders mit Pilotton eine andere ist.

EP 0 130 321 A2

Stand der Technik

Die Erfindung geht aus von einem Autoempfänger nach der Gattung des Anspruchs 1. Es ist bekannt, bei Autoempfängern den Empfang von Stereo-
und/oder Verkehrsfunksendern mit Hilfe von Signallampen oder Leuchtdioden,
die im Bedienteil des Emfängers angeordnet sind, anzuzeigen. Die Erkennung
dieser Sender erfolgt mittels Erkennungsschaltungen, welche auf die von
den Sendern zusätzlich ausgestrahlten Pilotfrequenzen ansprechen.

Aus der DE-AS 23 60 244 ist es bekannt, bei Heimempfängern als Flutlichtscheiben ausgebildete Skalenscheiben mit mehreren Lampen zu versehen und
zwischen den zur Skalenbeleuchtung vorgesehenen Lampen und der kürzeren
Schmalseite der Skalenscheibe optische Farbfilter anzuordnen. Die eine Lampe ist dem einen Wellenbereich zugeordnet und leuchtet die Skala in der
hierfür vorgesehen Farbe aus. Die andere Lampe ist für den anderen Wellenbereich vorgesehen und leuchtet die gleiche Skalenscheibe nach einer von
Hand erfolgten Wellenbereichsumschaltung in der für diesen Wellenbereich
vorgesehenen Farbe aus. Derartige Abstimmanzeigen lassen zwar ein Erkennen eingeschalteter Wellenbereiche zu, nicht aber ein Erkennen von mit
Pilotfrequenzen gekennzeichneten Sendern innerhalb eines Wellenbereiches.

...

# BLAUPUNKT-WERKE GMBH 33 HILDESHEIM, Robert-Bosch-Straße 200

<u>Vorteile der Erfindung</u>

Der erfindungsgemäße Autoempfänger mit den kennzeichnenden Merkmalen des Anspruchs 1 hat den Vorteil, daß die Lichtfarbe der Abstimmanzeige dem Bedienenden automatisch den Empfang eines mit einem Pilotton versehenen Senders, vorzugsweise eines Verkehrsfunksenders, anzeigt. Durch den Fortfall separater optischer Anzeigeelemente wird zudem das Bedienteil des Empfängers übersichtlicher und der Fahrer weniger von Verkehrsgeschehen abgelenkt.

Durch die in den Unteransprüchen aufgeführten Maßnahmen sind vorteilhafte Weiterbildungen und Ausgestaltungen des im Anspruch 1 angegebenen Autoempfängers möglich. Durch die Verwendung eines elektronischen Umschalters nach Anspruch 2 läßt sich in einfachster Weise die Umschaltung der einzelnen Lichtquellen erzielen. Eine nach dem Anspruch 3 ausgebildete Abstimmanzeigeeinrichtung läßt sich sehr preiswert herstellen. Besonders vorteilhaft ist die Verwendung einer Flüssigkristall-Anzeigevorrichtung nach Anspruch 4 sowie deren Ausgestaltung nach Anspruch 9. Die Verwendung von Farbfiltern nach Anspruch 5 gestattet den Einsatz von normalen farblosen Glühlampen, während Glühlampen mit gefärbten Gläsern bei einer Ausgestaltung nach Anspruch 6 keine zusätzlichen Farbfilter erfordern. Die Verwendung eines Stereo- bzw. Verkehrsfunk-Decoders als Erkennungsschaltung nach den Ansprüchen 7 bzw. 8 erfordert keinen zusätzlichen Aufwand, da diesen Decodern in der Regel beim Vorhandensein eines Pilottons eine Signalspannung entnehmbar ist.

. . .

**BLAUPUNKT-WERKE GMBH** 31 HILDESHEIM, Robert-Bosch-Straße 200

PLI-Hi Pieper/TEX2-Kh                  - 3 -                        23.6.1983
                                                                 R.Nr. 1781

Zeichnung

Ein Ausführungsbeispiel der Erfindung ist in der Zeichnung dargestellt. Es zeigen Figur 1 ein Blockschaltbild eines zur Erkennung von Verkehrsfunksendern ausgebildeten Autoempfängers, Figur 2 die Vorderansicht und Figur 3 eine Schnittzeichnung einer mit einer Flüssigkristall-Anzeigevorrichtung versehenen Abstimmanzeige des Empfängers.

Beschreibung des Ausführungsbeispiels

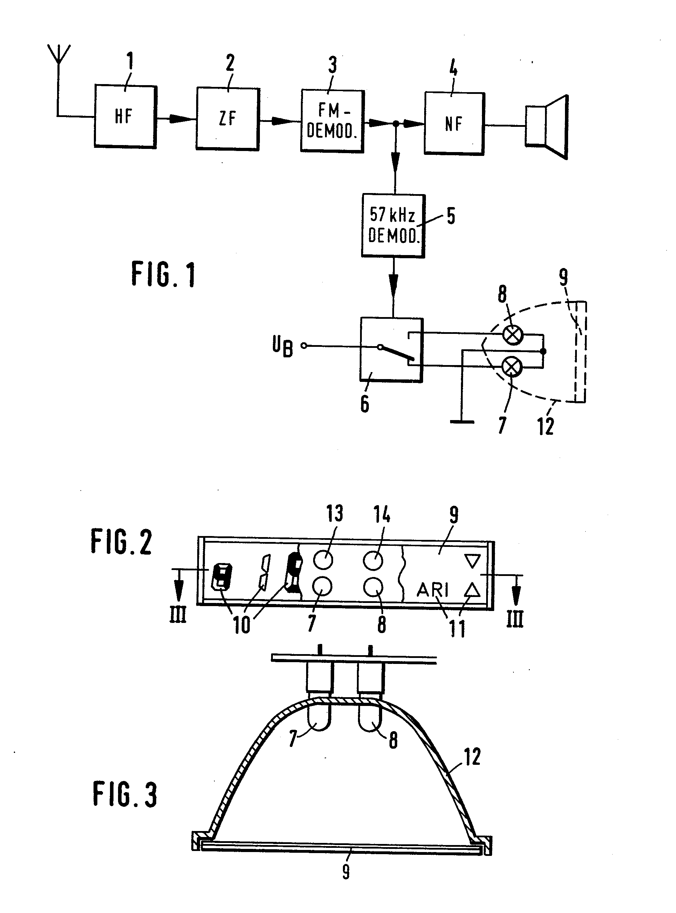

Ein zum Empfang von Verkehrsfunksendungen vorgesehener Autoempfänger nach Figur 1 weist in an sich bekannter Weise eine HF-Eingangsstufe 1, einen ZF-Verstärker 2, einen FM-Demodulator 3, einen NF-Verstärker 4 und eine auf den 57 kHz-Pilotton ansprechende Erkennungsschaltung 5 auf, die Teil eines Verkehrsfunk-Decoders ist. Der Ausgang der Erkennungsschaltung 5 ist mit dem Steuereingang eines elektronischen Umschalters 6 verbunden, dessen Eingangsklemme an eine Betriebsspannungsquelle $U_B$ angeschlossen ist. Die beiden Ausgangsklemmen des elektronischen Umschalters sind über Glühlampen 7, 8 unterschiedlicher Lichtfarbe mit Masse verbunden. Die Glühlampen 7, 8 dienen zur Beleuchtung einer als Abstimmanzeige vorgesehenen Negativ-Flüssigkristall-Anzeigevorrichtung 9 nach Figur 2 und Figur 3. An der Rückseite der mit Ziffern 10 und Symbolen 11 versehenen rechteckförmigen Flüssigkristall-Anzeigevorrichtung 9 ist ein parabelförmig gekrümmter Reflektor 12 angeordnet, der mit vier Glühlampen 7, 8, 13, 14 versehen ist.

. . .

0130321.

Wird mit dem Empfänger ein Sender empfangen, der kein Verkehrsfunksender ist, so spricht die Erkennungsschaltung 5 nicht an, der elektronische Umschalter 6 befindet sich in seiner Ruhestellung und legt somit die eine erste Lichtfarbe aufweisende Lampe 7 an die Betriebsspannungsquelle $U_B$. Ist der Empfänger dagegen auf einen Verkehrsfunksender abgestimmt, so gelangt von der 57 kHz-Erkennungsschaltung 5 ein Schaltsignal an den elektronischen Umschalter 6, wodurch dieser die Lampe 7 abschaltet und die eine zweite Lichtfarbe aufweisende Lampe 8 an die Betriebsspannungsquelle $U_B$ legt. Damit leuchtet die Abstimmanzeige beim Empfang von Verkehrsfunksendern in einer anderen Lichtfarbe.

Die Umschaltung der Lichtquellen ist nicht auf das Erkennung von Verkehrsfunksendern beschränkt. Sie läßt sich auch für die Anzeige von Stereo-Sendern anwenden. Hierbei ist lediglich eine Erkennungsschaltung für den 19 kHz-Pilotton erforderlich, wie sie in den üblichen Stereo-Decodern enthalten ist.

Beispielsweise zur zusätzlichen Erkennung einer Mono- oder Stereoübertragung eines Verkehrsfunksenders kann der elektronische Umschalter 6 in einer weiteren Arbeitsstellung beide Lichtquellen 7, 8 unterschiedlicher Lichtfarbe mit der Speisespannungsklemme $U_B$ verbinden, so daß eine der möglichen Übertragungsarten durch ein aus einer Mischfarbe bestehendes Licht angezeigt wird.

Autoempfänger

Ansprüche

1.  Autoempfänger mit einer beleuchteten Abstimmanzeige, einer Erkennungsschaltung für zusätzlich mit einem Pilotton versehene Sendungen und
einem von der Erkennungsschaltung steuerbaren elektrischen Schalter,
dadurch gekennzeichnet,
daß die Abstimmanzeige mindestens zwei zu ihrer Beleuchtung vorgesehene elektrische Lichtquellen (7, 8) unterschiedlicher Lichtfarbe aufweist, daß der Schalter (6) beim Empfang eines Senders mit einem vorgegebenen Pilotton die Lichtquellen (7, 8) umschaltet, derart, daß sich
die Lichtfarbe der Beleuchtung ändert.

2.  Autoempfänger nach Anspruch 1,
dadurch gekennzeichnet,
daß der Ausgang der Erkennungsschaltung (5) für den Pilotton mit dem
Steuereingang eines elektronischen Umschalters (6) verbunden ist,
welcher in seiner Ruhestellung die erste Lichtquelle (7) und in seiner
Arbeitsstellung die zweite Lichtquelle (8) mit einer Speisespannungsklemme ($U_B$) verbindet.

...

3.    Autoempfänger nach Anspruch 1 oder 2,

      dadurch gekennzeichnet,

      daß die Abstimmanzeige mit einer Abstimmskala versehen ist.


4.    Autoempfänger nach Anspruch 1 oder 2,

      dadurch gekennzeichnet,

      daß die Abstimmanzeige eine Flüssigkristall-Anzeigevorrichtung (9) aufweist.


5.    Autoempfänger nach einem der Ansprüche 1 bis 4,

      dadurch gekennzeichnet,

      daß als Lichtquellen (7, 8) Glühlampen vorgesehen sind und daß den Glühlampen optische Farbfilter zugeordnet sind.


6.    Autoempfänger nach einem der Ansprüche 1 bis 4,

      dadurch gekennzeichnet,

      daß als Lichtquellen (7, 8) Glühlampen mit gefärbten Gläsern vorgesehen sind.


7.    Autoempfänger nach Anspruch 1,

      dadurch gekennzeichnet,

      daß als Erkennungsschaltung (5) ein Verkehrsfunk-Decoder vorgesehen ist.


                                                          . . .

8.    Autoempfänger nach Anspruch 1,

dadurch gekennzeichnet,

daß als Erkennungsschaltung (5) ein Stereo-Decoder vorgesehen ist.


9.    Autoempfänger nach Anspruch 4,

dadurch gekennzeichnet,

daß die Flüssigkristall-Anzeigevorrichtung (9) an ihrer Rückseite einen Reflektor (12) aufweist, der mit mindestens zwei Lichtquellen (7, 8) unterschiedlicher Lichtfarbe versehen ist.


10.   Autoempfänger nach Anspruch 2

dadurch gekennzeichnet,

daß der elektronische Umschalter (6) in einer weiteren Arbeitsstellung beide Lichtquellen (7, 8) mit der Speisespannungsklemme ($U_B$)

verbindet.

FIG. 1

FIG. 2

FIG. 3